# EUROPEAN PATENT SPECIFICATION

(11) **EP 1 381 263 B1**
(45) Date of publication and mention of the grant of the patent: **13.02.2008**
(21) Application number: 03396069.1
(22) Date of filing: 08.07.2003
(51) Int. Cl.: H05K 7/20

(54) **Arrangement for air removal from a cabinet**
Anordnung zur Luftentfernung eines Schrankes
Système d'élimination d'air d'une armoire

(30) Priority: 12.07.2002 FI 20021376
(43) Date of publication of application: 14.01.2004
(73) Proprietor: Vacon Oyj, 65380 Vaasa (FI)
(72) Inventor: Koivisto, Yrjö, 66400 Laihia (FI)
(74) Representative: Järveläinen, Pertti Tauno Juhani

(56) References cited:
- CH-A- 633 930
- GB-A- 2 354 819
- US-A- 2 694 358

## Description

### BACKGROUND OF THE INVENTION

The invention relates to protecting electrical equipment, and in particular to protecting enclosed electrical devices that produce considerable heat, having the IP classification. This kind of arrangement protects an electrical device against ambient conditions, such as humidity and dust, and prevents inappropriate objects from getting inside the cabinet, while enabling sufficient ventilation for cooling down the equipment.

The maximum temperature of many electrical devices is strictly defined, and free circulation of air in the enclosure is thus frequently insufficient.

In US patent 5,800,258 the circulation of air is enhanced and it discloses a ventilation system for electrical devices producing considerable heat, in which fans are arranged in pairs between stacked units for discharging air from the middle part of the cabinet. It has been found, however, that this solution poses some considerable problems. Often, discharge of air from the middle part is not possible due to the size and location of the devices in the cabinet. GB 2 354 819 discloses a cabinet for a plurality of units which dissipate heat comprises a plenum chamber, a rack for mounting the units allowing passages for cooling air past the units, and a plurality of fan units for propelling air to flow in a forward direction from outside the cabinet through the passages into the plenum chamber and through an exhaust from the plenum chamber. The fan units are each connected to a power distribution unit by a power inlet plug and a power outlet socket so that a faulty fan unit can be removed while other fan unit(s) continue to cool the electronic units. The power inlet plug on each fan unit may mate automatically with the power outlet socket. The fan units may each have a flap valve arranged to prevent air flow in a reverse direction. The fan units may have backwardly curved impellers. CH 633 930 discloses a housing for electrical apparatuses is described which has inlet and outlet openings for cooling air. The said openings are ranged on only one side of the housing and are provided with a covering flap which can pivot. In the open position, said covering flap opens the air inlets and outlets but protects them against the ingress of water spray. When the covering flap is in the closed position, all the openings in the housing are covered with respect to the exterior. US 2,694,358 discloses a closure structure for an upright exhaust on a tractor or the like, and is further concerned with a cap that will automatically open when the engine is running and which will automatically close when the engine is shut off.

Electrical devices often produce so much heat that its removal requires large amounts of air. Introduction of large amounts of air into the cabinet and their discharge from the cabinet require a sufficient space for air passages in order to avoid high flow rates and unnecessary friction resulting from narrow passages. Means, such as filters and other various structural arrangements, for protecting the device from effects of ambient conditions also cause friction.

### BRIEF DESCRIPTION OF THE INVENTION

The object of the invention is thus to provide an arrangement such that problems that appear in connection with ventilating electrical devices that produce a lot of heat and protecting them against effects of ambient conditions will be prevented. This is achieved with a device, which is characterized by what is stated in the independent claim. The preferred embodiments of the invention are disclosed in the dependent claims.

The invention is based on the idea that a protective means is arranged in an enclosure of an electrical device, by which means it is possible to ensure sufficient ventilation for the electrical device that produces a lot of heat, while protecting the device against effects of ambient conditions.

Cooling inside the cabinet is implemented with an air transfer means, for instance a blower or a fan, whose function is to move replacement air coming through an air inlet arranged in the cabinet towards an air outlet arranged in the cabinet. The transfer means may be located in the vicinity of the inlet or the outlet or in the middle part of the cabinet.

In the arrangement of the invention sufficient cooling is implemented such that the passage for the air to be removed is arranged as free as possible and the air outlet is arranged in the upper part of the cabinet. The free passage reduces friction and so the transfer means need not be loaded excessively for obtaining a sufficient flow. Air rises upwards when heated, so it is advantageous to remove the air from the upper part of the cabinet.

For cooling, the best location for the arrangement would be the top surface of the cabinet, on the other hand, in extreme ambient conditions an advantageous location would be on the side of the cabinet, whereby it would be easier to stop the admission of a liquid substance into the cabinet.

The arrangement of the invention ensures that the air to be removed is led from the enclosure to the space surrounding it such that the electrical device or the cabinet thereof comprises a protective means. The protective means comprises a frame and protective covers that are movably arranged with respect to the frame. The protective means may consist of e.g. covers, lamellas, or other means, the position of which can be changed by means of an air flow. These protective means may move from the closed position that covers completely a ventilation opening surrounded by the frame to the open position that does not cover the opening.

The movement of the protective means with respect to the frame is dependent on the air flow produced in the electrical device or the cabinet thereof. At its simplest, the air flow produced in the device forces the protective means to open so as to ensure sufficient flow-through. It is essential that the protective means are arranged such that the air flow-through also enables protection against water and dust in accordance with the desired IP classification degree also when in the open position. Cooling of components that produce a lot of heat requires considerable amounts of air and thus it is possible to generate high flow rates. As the air flow rate is sufficiently high, liquid substances, such as water drops or any other liquid substance, are prevented from progressing directly against the flow, whereby the air flow will be part of the enclosure. The air flow flowing through the uncovered opening also prevents dust and other lighter solid particles from entering the cabinet through the outlet opening. In the closed position the tightness of the outlet opening is considerably better than in the open position, because the opening is then completely covered by a protective means or a plurality of protective means.

Enclosure classifications for electrical devices are defined in standards *SFS-EN 60529:1992* and *SFS-EN 60529*/*A1:2000,* which are direct translations of standards IEC 60529:1989 and IEC 60529/A1:2000 and EN 60529:1991 and EN 60529/A1:2000. The IP code is a code system, which indicates the degree of protection provided by enclosures against touching the hazardous parts, penetration of foreign objects or dust or water and providing additional information on protection. The protection class (IP) generally consists of two numbers. The first number indicates how electrical devices are protected against solid objects and the second number how they are protected against liquid substances. It is also possible to use an additional letter and a supplementing letter. The IP classes (the two first numbers) are as follows:

| First number (solid objects) | Second number (liquid substances) |
|---|---|
| 0 not protected | 0 not protected |
| 1 over 50 mm, e.g. a fist | 1 vertically falling water drops |
| 2 over 12.5 mm, e.g. fingers | 2 drops falling at an angle of max. 15 degrees |
| 3 over 2.5 mm, e.g. lines and tools | 3 water spraying at an angle of max. 60 degrees |
| 4 over 1 mm, e.g. wire | 4 water splashing from all directions |
| 5 dust-protected, slight admission allowed | 5 protected against low-power water jets, slight admission allowed |
| 6 completely dust-tight | 6 protected against powerful water jets, slight admission allowed |
| | 7 protected against effects of temporary immersion in water |
| | 8 protected against effects of continuous immersion in water under pressure |

For solid objects the IP classification level of the protective means of the invention can be achieved by a protective net, for instance. The protective net can be a wire mesh, a grid, a filtering cloth or other means preventing the admission of solid objects. In addition to the protective net, the protective means of the arrangement of the invention also prevents the admission of the solid objects whose admission can be prevented by said air flow. It is also possible to arrange the protective net to be changeable, whereby the device can be transferred to another space that optionally requires a different IP protection. It is possible to place the protective net above the protective means if sufficiently high frame is used, which allows the protective net to be placed sufficiently far apart from the protective means and thus allowing free opening of the protective means.

For liquid substances the IP classification level of the protective means can be achieved by determining how the protective means opens in order to provide sufficient flow for ensuring the desired IP class for liquid substances. Openability can be set as desired by changing the weight of the protective means, for instance. This can be implemented by changing the thickness of the protective means, or the material of the protective means can be changed to have different mass density (kg/m³). The protective means can be made of metal, plastic or other suitable material. The protective means can be exchangeable with a protective means having the protective properties of a different IP class. The IP class of the protective means can be found out by testing the openability of different covers. On the basis of the testing the protective means made in said manner and of said material can be determined for the IP class in advance. The IP class determination of the protective means is based on the minimum rate of the air flow that comes through the opened outlet. Instead of the protective means properties, or in addition thereto, the protective means can be provided with means which allow addition of one or more means for setting the openability of the protective means to be desired. The openability of the protective means can be adapted by arranging a counterweight, a spring or the like in connection with the protective means, by which the openability can be set to a given level. The openability of the protective means should also be limited by a stopper element for the protective means not to open excessively, whereby the protective means would not return to the closed position as the air flow decreases.

On the other hand, the opening of the protective means can be limited to a given level with the stopper element. Thus it will be easier to determine the openability of the protective means, because the standard size air outlet opening is known. In that case one only determines the minimum flow rate, at which said protective means opens, and the minimum flow rate within the range between the closed position and the open position of the protective means positions. The slower one of these minimum flow rates thus determines also the IP class of the protective means for liquid substances. If more effective cooling is desired, the amount of air to be removed should be increased, which results in a rise in the flow rate at the outlet opening, because the size of the outlet opening is constant. As the flow rate rises, the protection from liquid substances is enhanced, i.e. the protective means opens more easily. It is possible to limit the opening by configuring the protective means such that one edge of the protective means prevents the protective means from opening excessively, or the opening can be limited by a stopper element located outside the protective means, for instance.

In addition to the operation of the above-described arrangement, the present solution is characterized by a simple structure, whereby device assembly can be considerably simplified, its durability improved and its manufacturing costs reduced. In addition, the structure facilitates the design of electrical devices requiring large amounts of air and the means also serves as a protection for the device during installation (closed position).

It is also advantageous to provide the protective means with suitable means for different uses. Thus the operation of the protective means starts, for instance, immediately when the device starts running, the temperature of the device has exceeded a threshold value or the flow is sufficient. The means intended for detecting or opening comprises a mechanical, optical, electrical or electromagnetic means. However, the operation of the protective means can be controlled utilizing the control logic and actuators known per se.

### BRIEF DESCRIPTION OF THE DRAWINGS

In the following the invention will be described in greater detail in connection with preferred embodiments with reference to the attached drawings, in which
Figure 1 shows a protective means of the arrangement in the open position, the protective means being turned aside;
Figure 2 shows the arrangement secured on the top surface of a cabinet;
Figure 3 shows a solution, in which the protective means is secured to the top surface of a second protective cabinet and the air is conducted out from the inner cabinet through an air duct;
Figure 4 shows the protective means of the arrangement in the closed position, the protective means being set in a groove.

### DETAILED DESCRIPTION OF THE INVENTION

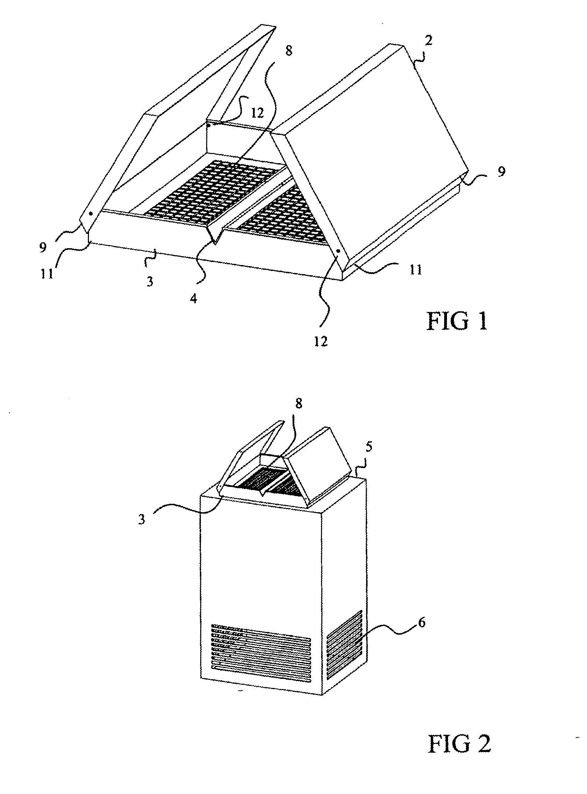

Figure 1 shows a protective means 2 of the arrangement in the open position, whereby the protective means 2 are turned aside. In the figure, two protective means 2 are secured to a frame 3. Between the protective means 2 there is arranged a groove 4, in which the protective means can sink as the air flow reduces. The groove also separates the protective means 2 from one another, in such a manner that a liquid substance or dust cannot penetrate between them into the cabinet. The groove arranged between the protective means also conducts the air flow such that the air flow is divided in two different sections in the solution of Figure 1.

Figure 2 shows the protective means of the arrangement secured to the top surface 5 of a cabinet. Intake air openings 6 of the cabinet to be protected are located in the lower part of the cabinet.

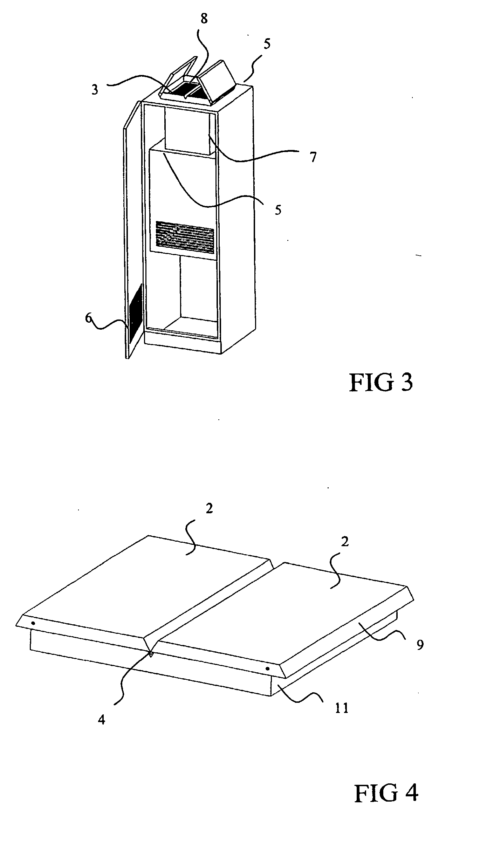

Figure 3 shows a solution, in which the protective means is secured to the top surface of a second protective cabinet 5 and the air is conducted out from the inner cabinet through a separate air duct 7 connecting the top surfaces of the two cabinets. The outer cabinet also has intake air openings 6 of its own, which are located in the lower part of the outer cabinet.

In Figures 1 to 3, the lower surface of the frame 3 is provided with a protective net 8 against solid particles. The protective net can be replaced by another protective net of different mesh size. In Figures 1 to 3, openability of the protective means 2 is limited by a stopper element 9 arranged in the protective means. The stopper element of the figures is a border arranged in the edge of the protective means, which border hits the frame edge 11 as the protective means turns to the open position and prevents the excessive turning of the protective means. The stopper element 9 enables the protective means 2 to return back to the closed position without any mechanical returning means as the air flow decreases. In the solution of Figures 1 to 3, the stopper element is not adjustable, but the protective means is readily detachable from its securing points 12. The protective means 2 can be secured to the frame with a hinge pin or any other known arrangement. The protective means can be replaced by a heavier or lighter protective means. The protective means may comprise a stopper element, by which the size of the air discharge opening is reduced so as to provide at least a desired flow rate at the discharge opening.

Figure 4 shows the protective means 2 of the arrangement in the closed position, whereby the protective means are set in the groove 4 and the protective means 2 of the arrangement also serve as a protection against dust and solid objects for the opening. As it can be seen from the figure, the protective means 2 cover the opening and they are also bent downwardly for the extended portion, which provides additional protection against liquids. The edge bendings shown in Figure 4 also make the protective means sturdier.

It is apparent to a person skilled in the art that as technology advances the basic idea of the invention can be implemented in a variety of ways. Thus the invention and its embodiments are not restricted to the above-described examples but they may vary within the scope of the claims.

## Claims

1. An arrangement for air removal from a cabinet for electrical devices producing heat, the cabinet having a given IP classification, the arrangement comprising:
at least one opening that constitutes an air outlet from the cabinet;
at least one protective means (2) that covers in an openable manner said at least one opening and that has an extreme open position as air flow increases and an extreme closed position as air flow decreases;
a stopper element (9) that determines the extreme open position of the protective means;
**characterized in that**
the stopper element (9) is adapted to limit the opening of the protective means (2) according to the given IP classification level such that:
with an arbitrary amount of air removed from the cabinet the air flow rate between the opening and the protective means (2) will be such that the IP classification requirements of the given IP classification level of the cabinet are fulfilled for liquid substances.

2. An arrangement as claimed in claim 1, **characterized in that** the protective means (2) is arranged to open in a limited manner with an additional weight.

3. An arrangement as claimed in claim 1 or 2, **characterized in that** the protective means (2) is arranged to open in a limited manner with a counterweight.

4. An arrangement as claimed in claims 1 to 3, **characterized in that** the protective means (2) is arranged to open in a limited manner with a spring.

5. An arrangement as claimed in claim 1, **characterized in that** in connection with the opening there is arranged a protective net (8) extending over the opening protecting against admission of solid particles.

6. An arrangement as claimed in claim 1, **characterized in that** the protective means is arranged in connection with the cabinet opening to be secured with a frame structure (3).

7. An arrangement as claimed in claim 5, **characterized in that** the protective net 8 is secured to the frame structure (3).

8. An arrangement as claimed in claim 5, **characterized in that** as the protective means (2) is in the closed position said protective means is arranged to prevent the admission of solid particles through the opening arranged in the upper part of the cabinet.

9. An arrangement as claimed in claim 5, **characterized in that** the protective net (8) is a wire mesh.

10. An arrangement as claimed in claim 5, **characterized in that** the IP class is arranged such that it can be changed for solid particles by replacing the protective net 8 with another protective net against solid particles having different protection properties.

11. An arrangement as claimed in any one of the preceding claims, **characterized in that** it is placed on the top surface (5) of the electrical device cabinet.

12. An arrangement as claimed in claim 1, **characterized in that** the extreme open position of the protective means (2) is adjustable such that the stopper element (9) arranged for limiting the openability is adjustable.

13. An arrangement as claimed in claim 1, **characterized in that** the protective means (2) is detachable such that the protective means is arranged to be detachable from its securing points (12).

## Patentansprüche

1. Anordnung zum Auslassen von Luft aus einem Schrank für elektrische Geräte, die Wärme erzeugen, wobei der Schrank eine vorgegebene IP-Klasse hat, wobei die Anordnung aufweist:
- mindestens eine Öffnung, die einen Luftauslass aus dem Schrank darstellt;
- mindestens ein Schutzmittel (2), das in einer zu öffnenden Weise die mindestens eine Öffnung abdeckt und das eine offene Endstellung hat, wenn der Luftstrom stark wird, und eine geschlossene Endstellung hat, wenn der Luftstrom schwach wird;
- ein Stoppelement (9), das die offene Endstellung des Schutzmittels bestimmt;
**dadurch gekennzeichnet, dass**
- das Stoppelement (9) dazu ausgelegt ist, die Öffnung des Schutzmittels (2) gemäß einem vorgegebenen IP-Klassifikationsniveau zu begrenzen, sodass:
mit einer beliebigen Menge aus dem Schrank ausgelassener Luft die Luftströmungsrate zwischen der Öffnung und dem Schutzmittel (2) so ist, dass die IP-Klassifikationsanforderungen des vorgegebenen IP-Klassifikationsniveaus des Schranks für Flüssigkeiten eingehalten werden.

2. Anordnung nach Anspruch 1, **dadurch gekennzeichnet, dass** das Schutzmittel (2) dazu ausgelegt ist, sich in einer begrenzten Weise mit einem zusätzlichen Gewicht zu öffnen.

3. Anordnung nach Anspruch 1 oder 2, **dadurch gekennzeichnet, dass** das Schutzmittel (2) dazu ausgelegt ist, sich in einer begrenzten Weise mit einem Gegengewicht zu öffnen.

4. Anordnung nach einem der Ansprüche 1 bis 3, **dadurch gekennzeichnet, dass** das Schutzmittel (2) dazu ausgelegt ist, sich in einer begrenzten Weise mit einer Feder zu öffnen.

5. Anordnung nach Anspruch 1, **dadurch gekennzeichnet, dass** im Zusammenhang mit der Öffnung ein Schutznetz (8) angeordnet ist, das sich über die Öffnung erstreckt, um gegen ein Einlassen von Feststoffpartikeln zu schützen.

6. Anordnung nach Anspruch 1, **dadurch gekennzeichnet, dass** das Schutzmittel im Zusammenhang mit der Schranköffnung angeordnet ist, um an einer Rahmenstruktur (3) befestigt zu werden.

7. Anordnung nach Anspruch 5, **dadurch gekennzeichnet, dass** das Schutznetz (8) an der Rahmenstruktur (3) befestigt ist.

8. Anordnung nach Anspruch 5, **dadurch gekennzeichnet, dass**, wenn das Schutzmittel (2) in der geschlossenen Position ist, das Schutzmittel dazu angeordnet ist, den Einlass von Feststoffpartikeln durch die im oberen Teil des Schranks angeordnete Öffnung zu verhindern.

9. Anordnung nach Anspruch 5, **dadurch gekennzeichnet, dass** das Schutznetz (8) ein Drahtgitter ist.

10. Anordnung nach Anspruch 5, **dadurch gekennzeichnet, dass** die IP-Klasse so ausgelegt ist, dass sie für Feststoffpartikel geändert werden kann, indem das Schutznetz (8) durch ein anderes Schutznetz gegen Feststoffpartikel mit anderen Schutzeigenschaften ersetzt wird.

11. Anordnung nach einem der vorhergehenden Ansprüche, **dadurch gekennzeichnet, dass** sie auf der oberen Oberfläche (5) des Schranks für elektrische Geräte angeordnet wird.

12. Anordnung nach Anspruch 1, **dadurch gekennzeichnet, dass** die offene Endstellung des Schutzmittels (2) **dadurch** eingestellt werden kann, dass das zum Begrenzen der Öffnungsfähigkeit angeordnete Stoppelement (9) einstellbar ist.

13. Anordnung nach Anspruch 1, **dadurch gekennzeichnet, dass** das Schutzmittel (2) **dadurch** entfernbar ist, dass das Schutzmittel dazu ausgelegt ist, von seinen Befestigungspunkten (12) entfernbar zu sein.

## Revendications

1. Système d'extraction d'air d'une armoire pour dispositifs électriques produisant de la chaleur, l'armoire ayant une classification IP donnée, le système comprenant :
au moins une ouverture qui constitue une sortie d'air de l'armoire ;
au moins un moyen de protection (2) qui couvre d'une manière ouvrable ladite au moins une ouverture et qui a une position extrême ouverte lorsque le flux d'air augmente et une position extrême fermée lorsque le flux d'air diminue ;
un élément de butée (9) qui détermine la position extrême ouverte du moyen de protection ;
**caractérisé en ce que**
l'élément de butée (9) est adapté pour limiter l'ouverture du moyen de protection (2) selon le niveau de classification IP donné de telle sorte que :
avec une quantité arbitraire d'air extraite de l'armoire, le débit d'air entre l'ouverture et le moyen de protection (2) soit tel que les exigences de classification IP du niveau de classification IP donné de l'armoire soient remplies pour les substances liquides.

2. Système selon la revendication 1, **caractérisé en ce que** le moyen de protection (2) est agencé pour s'ouvrir d'une manière limitée avec un poids additionnel.

3. Système selon la revendication 1 ou 2, **caractérisé en ce que** le moyen de protection (2) est agencé pour s'ouvrir d'une manière limitée avec un contrepoids.

4. Système selon les revendications 1 à 3, **caractérisé en ce que** le moyen de protection (2) est agencé pour s'ouvrir d'une manière limitée avec un ressort.

5. Système selon la revendication 1, **caractérisé en ce que**, en liaison avec l'ouverture, est agencé un filet de protection (8) s'étendant sur l'ouverture et assurant la protection contre l'admission de particules solides.

6. Système selon la revendication 1, **caractérisé en ce que** le moyen de protection est agencé en liaison avec l'ouverture de l'armoire pour être fixé avec une structure de cadre (3).

7. Système selon la revendication 5, **caractérisé en ce que** le filet de protection 8 est fixé à la structure de cadre (3).

8. Système selon la revendication 5, **caractérisé en ce que** lorsque le moyen de protection (2) est dans la position fermée, ledit moyen de protection est agencé pour empêcher l'admission de particules solides à travers l'ouverture agencée dans la partie supérieure de l'armoire.

9. Système selon la revendication 5, **caractérisé en ce que** le filet de protection (8) est un treillis métallique.

10. Système selon la revendication 5, **caractérisé en ce que** la classe IP est agencée de telle sorte qu'elle puisse être modifiée pour les particules solides en remplaçant le filet de protection 8 par un autre filet de protection contre les particules solides ayant des propriétés de protection différentes.

11. Système selon l'une quelconque des revendications précédentes, **caractérisé en ce qu'**il est placé sur la surface supérieure (5) de l'armoire de dispositif électrique.

12. Système selon la revendication 1, **caractérisé en ce que** la position extrême ouverte du moyen de protection (2) est ajustable de telle sorte que l'élément de butée (9) agencé pour limiter la possibilité d'ouverture soit réglable.

13. Système selon la revendication 1, **caractérisé en ce que** le moyen de protection (2) est détachable de telle sorte que le moyen de protection soit agencé pour être détachable de ses points de fixation (12).
